# EUROPEAN PATENT APPLICATION

(11) **EP 0 528 430 A1**
(43) Date of publication of application: **24.02.1993**
(21) Application number: 92114243.6
(22) Date of filing: 20.08.1992
(51) Int. Cl.: G01R 31/305

(54) **Method of temporary static fault imaging**

(30) Priority: 20.08.1991 JP 207701/91
(71) Applicant: NEC CORPORATION, Tokyo (JP)
(72) Inventor: Nakamura, Toyokazu, c/o NEC Corporation, Minato-ku, Tokyo (JP); Nikawa, Kiyoshi, c/o NEC Corporation, Minato-ku, Tokyo (JP); Tsujide, Tohru, c/o NEC Corporation, Minato-ku, Tokyo (JP)
(74) Representative: Glawe, Delfs, Moll & Partner

(57) **Abstract**

A temporary static fault imaging method starts with sequential application of test patterns to a semiconductor integrated circuit device in synchronism with relatively narrow timing pulses (i-3, i-2, i-1), and a timing pulse (i) is temporarily prolonged for a certain test pattern related to a failure origin of the semiconductor integrated circuit device so that a clear voltage contrast image is formed from secondary electron beams under application of the certain test pattern without sacrifice of accumulation of electric charges in the surface area of the semiconductor integrated circuit device.

## Description

### FIELD OF THE INVENTION

This invention relates to a fault analysis for a semiconductor integrated circuit device and, more particularly, to a fault analysis through radiation of electron beam onto the semiconductor integrated circuit device.

### DESCRIPTION OF THE RELATED ART

The integration density of a semiconductor integrated circuit has been continuously increased, and the circuit pattern thereof is now extremely complex. In fact, hundreds of thousands logic gates are incorporated in a semicustom-made integrated circuit, and component transistors come up to millions. In this situation, if a fault takes place in such a large scale semiconductor integrated circuit, a large amount of time and labor is consumed to analyze and specify the fault. Even if the circuit designer is involved in the analysis, more than one month would pass away. Therefore, it seems to be impossible for any person except for the circuit designer to specify the failure origin, and users also encounter difficulty in the analysis. The fault analysis is indispensable for improving production yield, and process engineers are expected to analyze and specify the failure origin in a manufacturing facility of, for example, an ASIC or a single-chip microcomputer.

In order to support the fault analysis, circuit designers tend to integrate various built-in diagnostic circuits. However, this approach enlarges the semiconductor chip, and a built-in diagnostic circuit designed for an integrated circuit is hardly generalized and, accordingly, can not divert to another integrated circuit.

T. C. May proposed an analyzing technology in "Dynamic Fault Imaging of VLSI Random Logic Device", 1984 IEEE/IRPS, pages 95 to 108, and the dynamic fault imaging is an attractive analyzing technology in view of wide applicability. In the dynamic fault imaging, when electron beam is radiated onto an large scale integrated circuit driven by an LSI tester, secondary electrons are produced in the large scale integrated circuit, and the intensity of the secondary electron beam is variable dependent upon the potential level on wirings incorporated in the large scale integration. If a wiring is in relatively high potential level, a significant amount of secondary electrons are backwardly attracted to the wiring, and, accordingly, the detectable secondary electron beam is relatively low in intensity. However, if another wiring is in relatively low potential level, most of the secondary electrons is detectable, and the secondary electron beam has relatively high intensity. Therefore, if the large scale integrated circuit is sequentially scanned with the electron beam, the potential of the wiring pattern is represented by the variation in the intensity of the secondary electron beam, and a voltage contrast image is produced from the variation of the secondary electron beam. The discrepancy between the voltage contrast image from a failure LSI and the corresponding voltage contrast image from a fault-free product shows the failure image, and the analyst can specify the location of the failure origin.

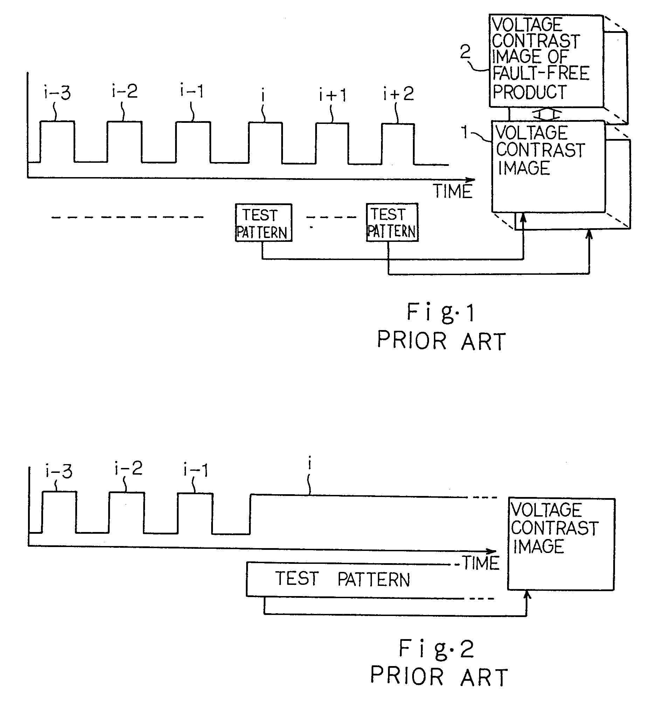

In the actual analysis, an LSI tester sequentially supplies test patterns or strings of data bits to signal pins of an large scale integrated circuit in synchronism with timing clocks (i-3), (i-2), (i-1), (i), (i+1) and (i+2) as shown in Fig. 1, and the sequential application of the test patterns is repeated. The large scale integrated circuit produces variable secondary electron beams, and an associated analyzer produces different voltage contrast images 1 from the respective test patterns. If a set of voltage contrast images 2 have been produced from the same test patterns supplied to a fault-free product, the voltage contrast images 1 of a suspect product are compared with the corresponding voltage contrast images 2 to see whether or not any discrepancy takes place therebetween. However, according to the prior art method of dynamic fault imaging, the analyzer is expected to form every voltage contrast image at every timing clock. If the test patterns are increased, the signal to noise ratio is deteriorated, and clear voltage contrast images are hardly formed. In order to form clear voltage contrast images, the fault analysis is prolonged, and the throughput is lowered. Thus, the first prior art method sequentially forms voltage contrast images at regular intervals.

In order to improve the signal to noise ratio, another method was proposed in "Marginal Fault Diagnosis Based on E-Beam Static Fault Imaging with CAD Interface" by Kuji, the Proceedings of International Test Conference, 1990, page 1049. According to the static fault imaging, a test pattern at the ith timing clock is fixed to the signal pins of an large scale integrated circuit as shown in Fig. 2, and the sequence is never recovered from the test pattern at the ith timing clock. In other words, a string of test patterns from the first to the ith are applied once. However, such a continuous application of the test pattern causes the surface area of the semiconductor chip for the large scale integrated circuit to accumulate electric charges, and the accumulated electric charges deteriorate the voltage contrast image.

### SUMMARY OF THE INVENTION

It is therefore an important object of the present invention to provide a method of forming a voltage contrast image which forms a clear image at high speed.

To accomplish the object, the present invention proposes to temporarily enter a static fault imaging mode.

In accordance with the present invention, there is provided a method of temporary static fault imaging, comprising the steps of: a) sequentially applying test patterns to an integrated circuit device in synchronism with first timing clocks for forming first voltage contrast images from a secondary electron beam emitted from the integrated circuit device under radiation of an electron beam; b) specifying a certain test pattern effectively imaging a failure origin in the integrated circuit device; and c) applying the certain test pattern to the integrated circuit device in synchronism with a second timing clock longer in pulse width than each of the first timing clocks for forming a second voltage contrast image from secondary electron beam emitted from the integrated circuit device under radiation of an electron beam.

### BRIEF DESCRIPTION OF THE DRAWINGS

The features and advantages of the method of temporary static fault imaging according to the present invention will be more clearly understood from the following description taken in conjunction with the accompanying drawings in which:
Fig. 1 is a view showing the sequence of the prior art method of dynamic fault imaging;
Fig. 2 is a view showing the sequence of the prior art method of static fault imaging;
Fig. 3 is a block diagram showing an analyzing system used for a method of temporary static fault imaging according to the present invention; and
Fig. 4 is a view showing the sequence of a temporary static fault imaging according to the present invention.

### DESCRIPTION OF THE PREFERRED EMBODIMENT

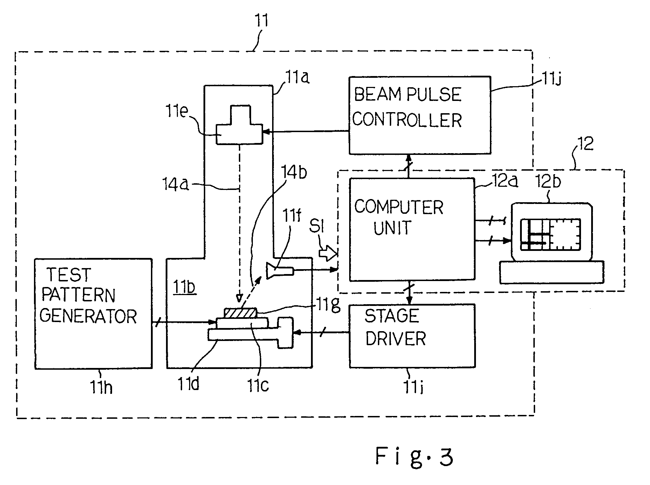

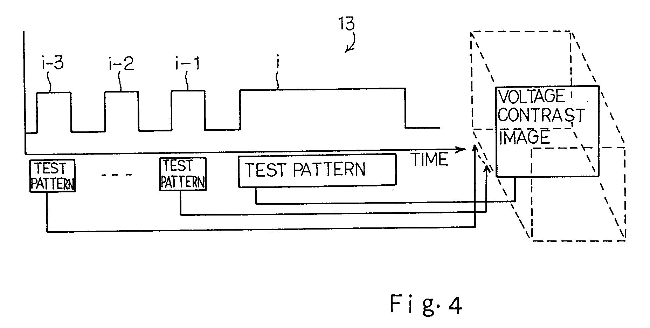

A sequence of a method embodying the present invention starts with preparation of an analyzing system embodying the present invention. The analyzing system is illustrated in Fig. 3, and largely comprises an electron beam tester 11 and a data processor 12 associated therewith. The electron beam tester 11 has a lens-barrel 11a defining a chamber 11b, and a test board 11c mounted on an x-y stage 11d, an electron beam projector 11e and a secondary electron detector 11f are installed in the chamber 11b. A semiconductor integrated circuit device 11g is placed on the test board 11c, and a test pattern generator 11h repeatedly supplies a string of test patterns through the test board 11c to the semiconductor integrated circuit device 11g in synchronism with a timing pulse train 13 (see Fig. 4). Though not shown in the drawings, the semiconductor integrated circuit device 11g has a wiring pattern implemented by a plurality of multi-level wiring strips. The x-y stage 11d is associated with a stage driver 11i, and is two-dimensionally movable with respect to the electron beam projector 11e. The electron beam projector 11e is associated with a beam pulse controller 11j, and intermittently radiates a string of electron beam pulses 14a onto the semiconductor integrated circuit device 11g. When the electron beam pulse 14a is incident into the large scale integrated circuit device 11g, secondary electrons are produced in the large scale integrated circuit device 11g, and a secondary electron beam 14b is radiated from the large scale integrated circuit 11g to the secondary electron detector 11f. Since the x-y stage 11d associated with the stage driver 11i changes the relative locational relation between the string of electron beam pulse 14a and the large scale integrated circuit device 11g, the secondary electron beam 14b is varied in the intensity depending upon potential level of the wiring pattern incorporated in the large scale integrated circuit 11g and depth of the wiring pattern.

The potential level of the wiring pattern is variable with a test pattern supplied from the test pattern generator 11h, and the depth is measured from the top surface of the large scale integrated circuit and the wiring pattern.

The intensity of the secondary electron beam 14b is varied depending upon the potential level and the topography of the wiring pattern, and the secondary electron detector 11f produces a detected signal S1 indicative of the intensity of the secondary electron beam 14b. The detected signal S1 is supplied to a computer unit 12a incorporated in the data processor 12, and sequentially stored in a memory unit of the computer unit 12a. If the x-y stage 11d sequentially changes the relative locational relation between the string of the electron beam 14a and the large scale integrated circuit device 11g, a series of the detected signals S1 form intensity data in the memory unit of the computer unit 12a, and the intensity data is representative of voltage contrast of the wiring pattern and of topography of the wiring pattern. The computer unit 12a executes a predetermined program sequence for data processing on the intensity data, and allows a display unit 12b to display an image for the wiring pattern on the screen thereof. The image provides information of the voltage contrast as well as of the topography of the wiring pattern to an analyst. When the computer unit 12a finds discrepancy as described hereinbelow, the computer unit 12a temporarily prolongs a timing pulse i. While a timing pulse remains in an active high level, an associated test pattern is continuously applied from the test pattern generator 11h to the semiconductor integrated circuit device 11g. When the time interval for the timing pulse i is expired, the test pattern generator 11h returns to the first test pattern, and the loop consisting of the first to the ith test patterns are repeatedly applied to the semiconductor integrated circuit device 11g.

If a fault takes place in the large scale integrated circuit device 11g, a wiring strip associated with the failure origin is different in potential level from the corresponding wiring strip incorporated in a fault-free product. Therefore, discrepancy takes place between the image for the fault product and the image for the fault-free product, and the analyst can easily localize the failure origin on the screen of the display unit 12b.

As described hereinbefore, the test pattern generator 11h repeatedly supplies a series of test patterns to the semiconductor integrated circuit device in synchronism with the timing pulse train 13. Before reaching the ith test pattern, the computer unit 12a causes the test pattern generator 11h to produce a string of test patterns in synchronism with relatively narrow timing pulses (i-3), (i-2) and (i-1), and dynamically produces voltage contrast images. However, if the ith test pattern suitable for imaging a failure origin is supplied to the semiconductor integrated circuit device 11g, the computer unit 12a prolongs the timing pulse (i), then the test pattern generator 11h continuously supplies the suitable test pattern to the semiconductor integrated circuit device 11g. The prolonged time interval for the suitable test pattern improves the signal to noise ratio of the detected signal S1, and a clear voltage contrast image is displayed on the screen of the display unit 12b. If the prolonged interval is expired, the computer unit 12a allows the test pattern generator 11h to return to the first test pattern and to supply the first to the i-1th test patterns in synchronism with the relatively narrow timing pulses again. While the first to the i-1th test patterns are sequentially supplied to the semiconductor integrated circuit device in synchronism with the relatively narrow pulses, excess electric charges are discharged from the surface area of the semiconductor integrated circuit device 11g. Thus, the analyzing system according to the present invention selectively enters the dynamic fault imaging mode and a quasi-static fault imaging mode, and recovers from the quais-static fault imaging mode to the dynamic fault imaging mode again. Therefore, the method according to the present invention is referred to as "Temporary Static Fault Imaging Method".

In order to confirm the advantages of the temporary static fault imaging method according to the present invention, a semiconductor integrated circuit device for an exchanger analyzer was placed on the test stage 11c. When a clock signal and/or signal timings were varied, malfunction took place in the semiconductor integrated circuit device, but the semiconductor integrated circuit device exactly achieved a predetermined operation under different signal timings. First, an LSI tester (not shown) was used for specifying pins related to the malfunction, and a first voltage contrast image was formed under the signal timings for the normal function. Thereafter, a second voltage contrast image was also formed under the signal timings for the malfunction, and extracted a failure image from the first and second voltage contrast images through comparison. Since the malfunction took place at 3316th pattern, the 3316 patterns were looped, and supplied to the semiconductor integrated circuit device. The 3316 patterns were supplied at intervals of 200 nano-second. Firstly, the test patterns were supplied to the semiconductor integrated circuit device in accordance with the prior art dynamic fault imaging method, time interval for each voltage contrast was 1/3316, and deteriorated the signal to noise ratio. A clear voltage contrast image was formed after about 5 minutes. However, when the time interval was prolonged to about 5 micro-second in accordance with the temporary static fault imaging method, a clear voltage contrast image was formed, and the image formation was 25 times faster than the prior art dynamic fault imaging method. The failure image was obtained at every 12 seconds, and the failure origin was quickly localized.

In another analysis, a set of voltage contrast images have been produced from a fault-free product and stored in the computer unit 12a. A suspect product is mounted on the test stage 11c, and voltage contrast images are formed from the suspect product. The set of voltage contrast images are sequentially compared with the corresponding voltage contrast images produced from the fault-free product, and a failure image is obtained on the basis of discrepancy between two sets of voltage contrast images.

Although particular embodiments of the present invention have been shown and described, it will be obvious to those skilled in the art that various changes and modifications may be made without departing from the spirit and scope of the present invention.

## Claims

1. A method of temporary static fault imaging, comprising the steps of:
a) sequentially applying test patterns to an integrated circuit device (11g) in synchronism with first timing clocks (i-3, i-2, i-1) for forming first voltage contrast images from a secondary electron beam (14b) emitted from said integrated circuit device under radiation of an electron beam (14a); and
b) specifying a certain test pattern effectively imaging a failure origin in said integrated circuit device, characterized by
the step of c) applying said certain test pattern to said integrated circuit in synchronism with a second timing clock (i) longer in pulse width than each of said first timing clocks for forming a second voltage contrast image from secondary electron beam emitted from said integrated circuit device under radiation of an electron beam.

2. A method of temporarily static fault imaging as set forth in claim 1, further comprising the step of d) comparing said second voltage contrast image with a corresponding voltage contrast image produced from a secondary electron beam under application of said certain test pattern to a corresponding fault-free integrated circuit device.
